(19)

**Europäisches Patentamt**
**European Patent Office**
**Office européen des brevets**

(11) **EP 4 559 589 A1**

(12) **EUROPEAN PATENT APPLICATION**

(43) Date of publication:
**28.05.2025 Bulletin 2025/22**

(21) Application number: **24214587.8**

(22) Date of filing: **21.11.2024**

(51) International Patent Classification (IPC):
***B06B 1/06*** (2006.01)

(52) Cooperative Patent Classification (CPC):
**B06B 1/0622; B06B 1/0629**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.11.2023 CN 202311553279**

(71) Applicant: **The Hong Kong Polytechnic University Hung Hom, Kowloon Hong Kong (CN)**

(72) Inventors:
- **DAI, Jiyan Hong Kong, 0000 (CN)**
- **LI, Guo Hong Kong, China, 0000 (CN)**

(74) Representative: **Cabinet Netter 36, avenue Hoche 75008 Paris (FR)**

(54) **ULTRASONIC TRANSDUCER AND METHOD FOR PREPARING THE SAME**

(57) The present application relates to the technical field of ultrasonic imaging technology, and provides an ultrasonic transducer and a method for preparing the same. The ultrasonic transducer includes a substrate layer (20), a piezoelectric layer (10), and an acoustic matching layer (30) laminated in sequence along the thickness direction (Z); the piezoelectric layer (10) includes a substrate (11), the substrate (11) includes a wiring area (113) and a plurality of piezoelectric array elements (111) distributed in a matrix along the row direction (X) and the column direction (Y), and two adjacent piezoelectric array elements (111) are bonded by an insulating adhesive (112), and the upper and lower surfaces of the piezoelectric array elements (111) and the insulating adhesive (112) are formed by a vacuum-plated electrode layer to form row and column strip electrodes, which can be formed by cutting and photolithography. The end of the first electrode layer is electrically connected to the first conductive element (40); the end of the second electrode layer is electrically connected to the second conductive element (50). The substrate layer (20) and the acoustic matching layer (30) can be directly in contact with the piezoelectric layer (10) for acoustic matching, respectively, which improves the acoustic matching effect between the piezoelectric array elements (111) and the substrate layer (20) as well as the acoustic matching layer (30).

EP 4 559 589 A1

**Description**

**TECHNICAL FIELD**

The present application relates to the technical field of ultrasonic imaging technology, more particularly to an ultrasonic transducer and a method for preparing the same.

**BACKGROUND**

With the continuous development of ultrasonic imaging technology, the application of ultrasonic imaging systems in medical diagnosis is also increasing. Real-time three-dimensional ultrasonic imaging technology is one of the important means of medical imaging diagnosis today. This technology can improve the scanning frame rate and meet the high-quality imaging requirements. Compared with the traditional single-element and one-dimensional array ultrasonic transducers, the two-dimensional array phased array system is an effective means to solve real-time three-dimensional ultrasonic imaging. It can focus in two directions and greatly improve the detection spatial resolution.

The key component of the ultrasonic imaging device for three-dimensional ultrasonic imaging is the two-dimensional array ultrasonic transducer. This is because the two-dimensional array ultrasonic transducer (i.e., the two-dimensional array phased array system) can focus in two directions, the detection spatial resolution is higher, and the data acquisition process is fast and stable. It can freely deflect and focus without moving and rotating to achieve three-dimensional imaging. If time is calculated into another dimension, a four-dimensional image can be generated.

The two-dimensional array ultrasonic transducer includes a large number of array elements distributed in a matrix manner, each array element is small in size and each array element needs to be independently wired. At the same time, an acoustically matched substrate layer and an acoustic matching layer are respectively provided on both sides of the array element. However, in the existing ultrasonic transducers, the acoustic matching effect between the array element and the substrate layer and the acoustic matching layer needs to be improved.

**SUMMARY**

It is an objective of the present application to provide an ultrasonic transducer and a method for preparing the same, aiming to solve the technical problem that the acoustic matching effect of the existing ultrasonic transducer needs to be improved.

In the first aspect, the present application provides an ultrasonic transducer, the ultrasonic transducer includes a substrate layer, a piezoelectric layer, and an acoustic matching layer laminated in sequence along a thickness direction; the piezoelectric layer includes a substrate, the substrate includes a wiring area and a plurality of piezoelectric array elements distributed at intervals in a matrix along a row direction and a column direction, two adjacent piezoelectric array elements are bonded by an insulating adhesive, and the wiring area is connected to outer sides of the plurality of piezoelectric array elements; a plurality of first electrode layers distributed at intervals in the row direction are arranged on a side of the substrate adjacent to the substrate layer, each of the plurality of first electrode layers covers a column of the piezoelectric array elements, a plurality of second electrode layers distributed at intervals in the column direction are arranged on a side of the substrate adjacent to the acoustic matching layer, each of the plurality of second electrode layers covers a row of the piezoelectric array elements; and the thickness direction is perpendicular to the row direction and the column direction respectively;

at least one end of each of the plurality of first electrode layers in the column direction extends to the wiring area, and is electrically connected to a first conductive element in the wiring area; at least one end of each of the plurality of second electrode layers in the row direction extends to the wiring area, and is electrically connected to a second conductive element in the wiring area.

In one embodiment, both ends of each of the plurality of first electrode layers in the column direction extend to the wiring area and are alternately connected with the first conductive element;.

In one embodiment, both ends of each of the plurality of second electrode layers in the row direction extend to the wiring area and are alternately connected with the second conductive element.

In one embodiment, a length of each of the plurality of first electrode layers extends to the wiring area is 1mm-3mm.

In one embodiment, a length of each of the plurality of second electrode layers extends to the wiring area is 1mm-3mm.

In one embodiment, each of the plurality of first electrode layers and/or each of the plurality of second electrode layers comprises an adhesion-enhancing layer, a main conductive layer, and an anti-oxidation layer sequentially laminated on the substrate along the thickness direction.

In one embodiment, a material of the adhesion-enhancing layer is at least one selected from a group of a chromium, a titanium, an aluminum, a nickel, and a tin.

In one embodiment, a material of the main conductive layer is at least one selected from a group of a copper, a silver, and a platinum.

In one embodiment, a material of the anti-oxidation layer comprises at least one selected from a group of a gold, an aluminum, an iron, a niobium, a zirconium, and a stainless steel.

In one embodiment, a thickness of the adhesion-enhancing layer is 20nm-30nm.

In one embodiment, a thickness of the main conductive layer is 500nm-3000nm.

In one embodiment, a thickness of the anti-oxidation layer is 50nm-100nm.

In one embodiment, a thickness of each of the plurality of first electrode layers is less than or equal to 10 $\mu$ m.

In one embodiment, a thickness of each of the plurality of second electrode layers is less than or equal to 10 $\mu$ m.

In one embodiment, a material of each of the plurality of piezoelectric array elements is at least one selected from a group of a lead magnesium niobate titanate single crystal, a barium titanate barium yttrium lead zenate single crystal, a zirconium beryllium titanate single crystal, a sodium niobate phosphate single crystal, and a lithium niobate single crystal; and a material of the insulating adhesive is at least one selected from a group of an epoxy resin, a polyurethane, a polyimide, and a polysulfone.

In one embodiment, both ends of the substrate in the column direction are exposed to the piezoelectric layer.

In one embodiment, both ends of the substrate in the row direction are exposed to the acoustic matching layer.

In one embodiment, a thickness of the substrate is 50$\mu$m-1500$\mu$m.

In one embodiment, the acoustic matching layer comprises a first matching layer and a second matching layer sequentially arranged on the piezoelectric layer along the thickness direction, an acoustic impedance of each of the plurality of piezoelectric array elements is 25 MRayl-35 MRayl, an acoustic impedance of the first matching layer is less than 20 MRayl and greater than an acoustic impedance of the second matching layer, and the acoustic impedance of the second matching layer is greater than 2 MRayl.

In one embodiment, a material of the first matching layer is a mixture of an alumina powder and an epoxy resin.

In one embodiment, a material of the second matching layer is the epoxy resin.

In one embodiment, a thickness of the first matching layer is 90 $\mu$ m-110 $\mu$ m.

In one embodiment, a thickness of the second matching layer is 50 $\mu$ m-70 $\mu$ m.

In one embodiment, a center frequency of the ultrasonic transducer is 1 MHz-30 MHz.

In one embodiment, a thickness of the substrate layer is 3mm-10 mm.

In the second aspect, the present application provides a method for preparing an ultrasonic transducer, and the method includes following steps:

S100: cutting a substrate into a plurality of piezoelectric array elements distributed in a matrix along a row direction and a column direction, filling a space between two adjacent piezoelectric array elements with an insulating adhesive, and connecting a wiring area on outer sides of the plurality of piezoelectric array elements;

S200: plating a plurality of first electrode layers and a plurality of second electrode layers on both sides of the substrate along a thickness direction, wherein each of the plurality of first electrode layers covers a column of the piezoelectric array elements, and each of the plurality of second electrode layers covers a row of the piezoelectric array elements;

S300: electrically connecting a first conductive element to at least one end of each of the plurality of first electrode layers extending to the wiring area, and covering each of the plurality of first electrode layers with the substrate layer; and

S400: electrically connecting a second conductive element to at least one end of each of the plurality of second electrode layers extending to the wiring area, and covering each of the plurality of second electrode layers with the acoustic matching layer. The second conductive element and the acoustic matching layer are staggered on a plane where the plurality of second electrode layers are located.

In one embodiment, the step S100 includes following steps:

S101: grinding the substrate;
S102: polishing the substrate after grinding;
S103: cutting the substrate along the row direction;
S104: filling incisions formed by cutting the substrate along the row direction with the insulating adhesive having a viscosity of 80cPs-100cPs, and curing the insulating adhesive;
S105: cutting the substrate along the column direction;
S106: filling incisions formed by cutting the substrate along the column direction with the insulating adhesive having a viscosity of 80cPs-100cPs, and curing the insulating adhesive;
S107: grinding the substrate to remove excess insulating adhesive.
In one embodiment, the step S200 includes following steps:
S201: sputtering and depositing an adhesion-enhancing layer, a main conductive layer, and an anti-oxidation layer on both sides of the substrate in sequence, so that the plurality of first electrode layers and the plurality of second electrode layers are formed on both sides of the substrate respectively;
S202: cutting the plurality of first electrode layers along the column direction, and filling incisions formed by the cutting with the insulating adhesive; and
S203: cutting the plurality of second electrode layer along the row direction, and filling incisions formed by the cutting with with insulating adhesive.

In one embodiment, the step of electrically connecting the first conductive element to at least one end of the first electrode layer specifically includes:

S301: alternately connecting the first conductive element to both ends of each of the plurality of first electrode layers;

S302: fixing an end of the first conductive element to each of the plurality of first electrode layers by the insulating adhesive; and

S303: compressing a bonding pad of the first conductive element to connect the bonding pad of the first conductive element to an end of each of the plurality of first electrode layers.

The ultrasonic transducer and the method for preparing the same provided in the present application have the following beneficial effects: at least one end of the first electrode layer is exposed in the area of the piezoelectric array elements and is used to be electrically connected to the first conductive element, and the first conductive element is not arranged in the area of the piezoelectric array elements, so that the piezoelectric layer and the substrate layer can be directly contacted for acoustic matching; at least one end of the second electrode layer is exposed in the area of the piezoelectric array elements and is used to be electrically connected to the second conductive element, and the second conductive element is not arranged between the second electrode layer and the acoustic matching layer, so that the piezoelectric layer and the acoustic matching layer can be directly contacted for acoustic matching, thus the acoustic matching effect of the piezoelectric array element and the substrate layer and the acoustic matching layer is improved.

**BRIEF DESCRIPTION OF THE DRAWINGS**

In order to more clearly illustrate the technical solutions in the embodiments of the present application, the drawings required for use in the embodiments or prior art descriptions are briefly introduced below. Obviously, the drawings described below are only some embodiments of the present application. For those skilled in the art, other drawings can be obtained based on these drawings without creative labor.

FIG. 1 is a structural schematic view of the structure of an ultrasonic transducer provided in an embodiment of the present application;
FIG. 2 is an enlarged view of A in FIG. 1;
FIG. 3 is a structural schematic view of the substrate of an ultrasonic transducer provided in an embodiment of the present application;
FIG. 4 is another perspective view of an ultrasonic transducer provided in an embodiment of the present application;
FIG. 5 is a cross-sectional view of FIG. 4;
FIG. 6 is a partial enlarged view of FIG. 5;

FIG. 7 is another perspective view of an ultrasonic transducer provided in an embodiment of the present application;
FIG. 8 is an enlarged view of B in FIG. 7;
FIG. 9 is another perspective view of an ultrasonic transducer provided in an embodiment of the present application;
FIG. 10 is a cross-sectional view of FIG. 9;
FIG. 11 is a partial enlarged view of FIG. 10;
FIG. 12 is a test diagram of the electromechanical coefficient of an ultrasonic transducer provided in an embodiment of the present application;
FIG. 13 is a relationship diagram between a pulse echo signal and a spectrum of an ultrasonic transducer provided in an embodiment of the present application; and
FIG. 14 is a flow chart of a method for preparing an ultrasonic transducer provided in an embodiment of the present application.

In the drawings, the reference numerals are listed:

X-row direction; Y-column direction; Z-thickness direction;
10-piezoelectric layer; 11-substrate; 111-piezoelectric array element; 112-insulating adhesive; 113-wiring area; 114-support body; 12-first electrode layer; 13-second electrode layer; 14-adhesion-enhancing layer; 15-main conductive layer; 16-anti-oxidation layer;
20-substrate layer;
30-acoustic matching layer; 31-first matching layer; 32-second matching layer;
40-first conductive element; 41-first insulating plate; 42-first conductive circuit; and
50-second conductive element; 51-second insulating plate; 52-second conductive circuit.

**DETAILED DESCRIPTION OF EMBODIMENTS**

The embodiments of the present application are described in detail below, and examples of the embodiments are shown in the accompanying drawings, where the same or similar reference numerals throughout represent the same or similar elements or elements with the same or similar functions. The embodiments described below with reference to the accompanying drawings are exemplary and are intended to be used to explain the present application, and cannot be understood as limiting the present application.

Reference throughout the application to "one embodiment" or "an embodiment" means that a particular feature, structure, or characteristic described in connection with the embodiment is included in at least one embodiment of the present application. Thus, when the phrases "in one embodiment" or "in some embodiments" appear in various places throughout the application, not all references are to the same embodiment. Furthermore, in one or more embodiments, the particular features, structures, or characteristics may be combined in any suitable manner.

In the description of the present application, it should be understood that the terms "length", "width", "up", "down", "front", "back", "left", "right", "vertical", "horizontal", "top", "bottom", "inside", "outside" and the like indicate positions or positional relationships based on the positions or positional relationships shown in the drawings, and are only for the convenience of describing the present application and simplifying the description, rather than indicating or implying that the device or element referred to must have a specific position, be constructed and operated in a specific position, and therefore cannot be understood as limiting the present application.

In addition, the terms "first" and "second" are only used for descriptive purposes, and cannot be understood as indicating or implying relative importance or implicitly indicating the number of technical features indicated. Therefore, the features defined as "first" and "second" may explicitly or implicitly include one or more of the features.

In the present application, unless otherwise clearly specified and defined, the terms "installed", "connected", "connect", "fixed" and the like should be understood in a broad sense, for example, it can be a fixed connection, a detachable connection, or an integral one; it can be a mechanical connection or an electrical connection; it can be directly connected or indirectly connected through an intermediate medium, it can be the internal connection of two elements or the interaction relationship between two elements. For ordinary technicians in this field, the specific meanings of the above terms in the present application can be understood according to specific circumstances.

## Embodiment 1

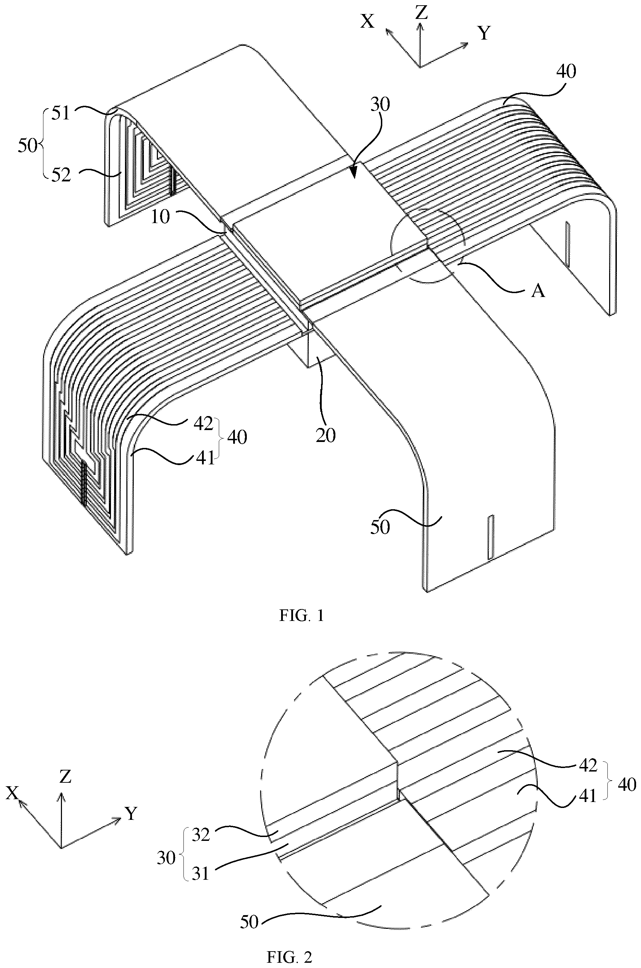

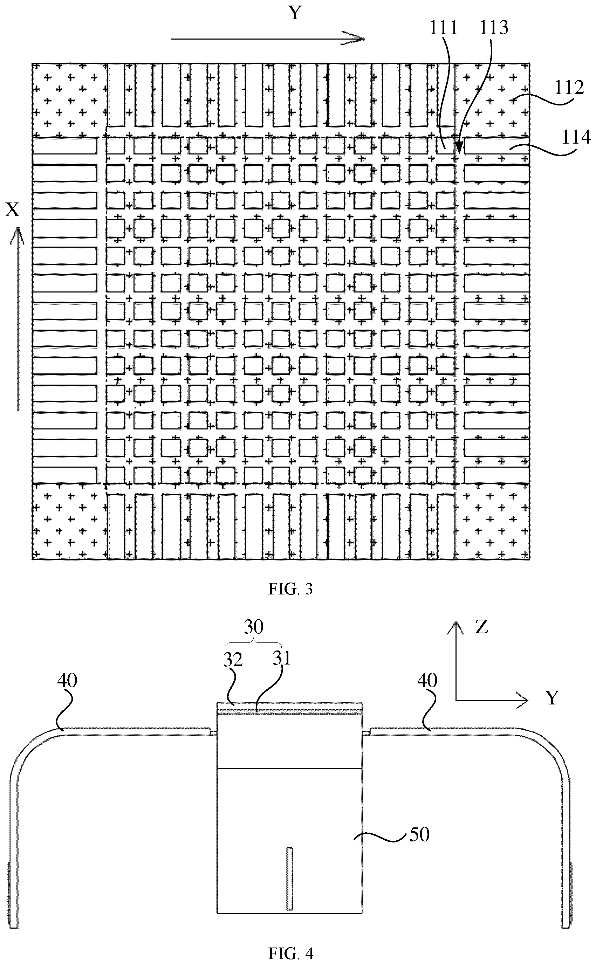

As shown in FIGS. 1 and 2, the ultrasonic transducer provided in the present application is provided with a row direction X, a column direction Y and a thickness direction Z, and the thickness direction Z is perpendicular to the row direction X and the column direction Y respectively. Specifically, the angle between the row direction X and the column direction Y is 10°-170°. Optionally, the row direction X is the length direction of the ultrasonic transducer, and the column direction Y is the width direction of the ultrasonic transducer; or, the row direction X is the width direction of the ultrasonic transducer, and the column direction Y is the length direction of the ultrasonic transducer; or, the row direction X and the column direction Y are different from both the length direction and the width direction of the ultrasonic transducer. The ultrasonic transducer includes a substrate layer 20, a piezoelectric layer 10 and an acoustic matching layer 30 laminated in sequence along the thickness direction Z. In conjunction with FIG. 3 , the piezoelectric layer 10 includes a substrate 11, and the substrate 11 includes a wiring area 113 and a plurality of piezoelectric array elements 111 that are distributed at intervals in a matrix manner along the row direction X and the column direction Y In other words, the plurality of piezoelectric array elements 111 include a plurality of rows of piezoelectric array elements 111, and the plurality of rows of piezoelectric array elements 111 are distributed in the column direction Y, and the plurality of piezoelectric array elements 111 in each row of piezoelectric array elements 111 are sequentially arranged in the row direction X; or in other words, the plurality of piezoelectric array elements 111 include a plurality of columns of piezoelectric array elements 111, and the plurality of columns of piezoelectric array elements 111 are distributed in the row direction X, and the plurality of piezoelectric array elements 111 in each column of piezoelectric array elements 111 are sequentially arranged in the column direction Y Two adjacent piezoelectric array elements 111 are bonded by an insulating adhesive 112, that is, two adjacent piezoelectric array elements 111 are insulated, and the insulating adhesive 112 connects the plurality of piezoelectric array elements 111 into one piece. The wiring area 113 is connected to the outer sides of the plurality of piezoelectric array elements 111. The plurality of piezoelectric array elements 111 surround an array element area, and the area outside the edges of the plurality of piezoelectric array elements 111 (refer to the dotted lines in FIG. 3 ) is the wiring area 113. A plurality of first electrode layers 12 spaced apart along the row direction X are provided on one side of the substrate 11 adjacent to the substrate layer 20, and each first electrode layer 12 covers a column of piezoelectric array elements 111, that is, the number of first electrode layers 12 corresponds to the number of columns M of the piezoelectric array elements 111, and the first electrode layers 12 extend along the column direction Y, and one first electrode layer 12 is in contact and conduction with a column of piezoelectric array elements 111. A plurality of second electrode layers 13 are arranged on one side of the substrate 11 adjacent to the acoustic matching layer 30 and spaced apart along the column direction Y Each second electrode layer 13 covers a row of piezoelectric array elements 111. Each second electrode layer 13 covers a row of piezoelectric array elements 111, that is, the number of second electrode layers 13 corresponds to the number of rows N of piezoelectric array elements 111. The second electrode layers 13 extend along the row direction X, and one second electrode layer 13 is in contact and conduction with a row of piezoelectric array elements 111.

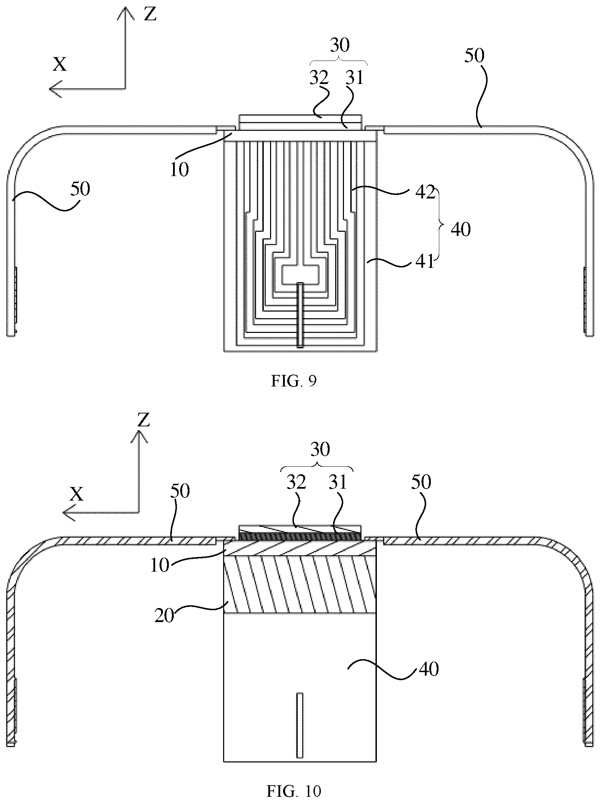

In conjunction with FIGS. 4 to 6, at least one end of each first electrode layer 12 in the column direction Y extends to the wiring area 113, and is electrically connected to the first conductive element 40 in the wiring area 113. In conjunction with FIGS. 9 to 11, at least one end of each second electrode layer 13 in the row direction X extends to the wiring area 113, and is electrically connected to the second conductive element 50 in the wiring area 113.

In the embodiment, at least one end of each first electrode layer 12 extends to the wiring area 113, which is convenient for electrical connection with the first conductive element 40. The first conductive element 40 is not arranged between the piezoelectric array element 111 and the substrate layer 20, so that the piezoelectric layer 10 and the substrate layer 20 can be directly in contact for acoustic matching, thereby the efficiency of acoustic wave transmission and the clarity and quality of ultrasonic signals is improved. At least one end of each second electrode layer 13 extends to the wiring area 113, which is convenient for electrical connection with the second conductive element 50. The second conductive element 50 is not arranged between the piezoelectric array element 111 and the acoustic matching layer 30, so that the piezoelectric layer 10 and the acoustic matching layer 30 can be directly in contact for acoustic matching, thereby the efficiency of acoustic wave transmission and the clarity and quality of ultrasonic signals is improved, an thus the acoustic matching effect between the piezoelectric array element 111 and the substrate layer 20 and the acoustic matching layer 30 is improved.

The traditional wiring method of ultrasonic transducers is that one side of each piezoelectric array element 111 is independently connected to a wire, and the total number of wiring operations is the product of the number of rows and the number of columns (N*M). The wiring is complicated, and the wire separates the piezoelectric array element 111 and the acoustic matching layer 30, resulting in energy loss when the acoustic waves are transmitted between the piezoelectric array element 111 and the acoustic matching layer 30. It may cause the acoustic waves to be reciprocated between the piezoelectric array element 111 and the wire, or between the wire and the acoustic matching layer 30, generating unnecessary reflected waves and interference waves, which interfere with the clarity and quality of the ultrasonic signal. In the ultrasonic transducer provided by the present application, the first conductive element 40 and the second conductive element 50 are located on both sides of the substrate 11, and the wiring operation space is larger, which is conducive to reducing the wiring difficulty. The first conductive element 40 is electrically connected to the first electrode layers 12, and the number of wiring operations is the same as the number of columns M of the piezoelectric array element 111. The second conductive element 50 is electrically connected to the second electrode layers 13, and the number of wiring operations is the same as the number of rows N of the piezoelectric array element 111. The total number of wiring operations is the sum of the number of rows and the number of columns (N+M), which improves the wiring efficiency, and only the row and column electrode intersection area of the first electrode layers 12 and the second electrode layers 13 will be excited and detected ultrasonic vibration. The first conductive element 40 is not located between the piezoelectric array element 111 and the piezoelectric layer 10, and the second conductive element 50 is not located between the piezoelectric array element 111 and the acoustic matching layer 30, which will not affect the resonant frequency, frequency response and stability of the ultrasonic transducer, and will not damage the connection between the substrate layer 20 and the piezoelectric layer 10, as well as the piezoelectric layer 10 and the acoustic matching layer 30, thereby the durability and reliability of the ultrasonic transducer are improved.

In some embodiments, the piezoelectric array element 111 is square, so that the row direction X and the column direction Y are perpendicular to each other, and the longitudinal and lateral dimensions of the piezoelectric array element 111 are consistent, which is conducive to cutting and filling the insulating adhesive 112, so that the lateral and longitudinal directions of acoustic performance are consistent.

Specifically, the side length of the piezoelectric array element 111 is 80μm-100μm, the spacing between two adjacent piezoelectric array elements 111 is 10μm-50μm, and the center distance between two adjacent piezoelectric array elements 111 is 100μm-150μm. In this way, the adjacent spacing and center distance of the piezoelectric array element 111 are small, which can provide higher spatial resolution, so as to more accurately capture subtle details and signal changes, and can provide a wide frequency response range. The small adjacent spacing is conducive to reducing the interference and attenuation that may exist in the transmission process of the received signal.

Optionally, the side length of the piezoelectric array element 111 is 80μm, 90μm or 100μm, the spacing between two adjacent piezoelectric array elements 111 is 10μm, 20μm, 30μm or 50μm, and the center distance between two adjacent piezoelectric array elements 111 is 100μm, 120μm, 130μm or 150μm.

In one of the embodiments, the material of the piezoelectric array element 111 is a lead magnesium niobate titanate single crystal, a barium titanate barium yttrium lead zenate single crystal, a zirconium beryllium titanate single crystal, a sodium niobate phosphate single crystal, or a lithium niobate single crystal.

Optionally, the material of the piezoelectric array element 111 is PMN-0.28PT, the piezoelectric constant $d33 \geq 2000pC/N$ and the electromechanical coupling coefficient k33-0.92.

In one of the embodiments, the insulating adhesive 112 is used to fix the piezoelectric array element 111 and reduce the crosstalk interference between two adjacent piezoelectric array elements 111. The material of the insulating adhesive 112 can be at least one selected from a group of an epoxy resin, a polyurethane, a polyimide and a polysulfone, which can not only achieve insulation between the piezoelectric array elements 111, but also be bonded to the piezoelectric array elements 111.

Specifically, in conjunction with FIG. 3, the wiring area 113 can be located at one or both ends of the plurality of piezoelectric array elements 111 in the row direction X, so as to support the first electrode layers 12 exposed to the plurality of piezoelectric array elements 111; and the wiring area 113 can be located at one or both ends of the plurality of piezoelectric array elements 111 in the column direction Y, so as to support the second electrode layers 13 exposed to the plurality of piezoelectric array elements 111. Optionally, when only one end of each first electrode layer 12 in the column direction Y needs to extend to the wiring area 113, the wiring area 113 can be located at one end or both ends of the plurality of piezoelectric array elements 111 in the column direction Y; when both ends of each first electrode layer 12 in the column direction Y need to extend to the wiring area 113, the wiring area 113 is located at both ends of the plurality of piezoelectric array elements 111 in the column direction Y

In one of the embodiments, in conjunction with FIG. 3, the wiring area 113 does not generate a piezoelectric signal and does not actively excite mechanical vibration. The wiring area 113 includes a plurality of support bodies 114. The support body 114 can be a piezoelectric substrate, an insulating ceramic, a glass or a high-resistance silicon wafer, which is not limited here. Two adjacent support bodies 114 are connected by an insulating adhesive 112, and the support body 114 and the array element area are connected by the insulating adhesive 112. The plurality of support bodies 114 are located at one or both ends of the array element area in the row direction X and correspond one-to-one with each row of piezoelectric array elements 111, and are located at one or both ends of the array element area in the column direction Y and correspond one-to-one with each column of piezoelectric array elements 111.

Optionally, in conjunction with FIG. 3, the first, third, and fifth support bodies 114 on the left side from top to bottom are connected to the first conductive circuit 42 of the first conductive element 40; and the second, fourth, and sixth support bodies 114 on the right side from top to bottom are connected to the first conductive circuit 42 of the first conductive element 40, and the like. The first, third, and fifth support bodies 114 on the upper side from left to right are connected to the second conductive circuit 52 of the second conductive element 50; and the second, fourth, and sixth support bodies 114 on the lower side from left to right are connected to the second conductive circuit 52 of the second conductive element 50, and the like. In this way, the first conductive elements 40 are alternately connected in the column direction Y, and the second conductive elements 50 are alternately connected in the row direction X, so as to increase the wire spacing and reduce electrical crosstalk.

In one of the embodiments, the thickness of the substrate 11 is 50μm-1500μm, the thickness is relatively smaller, which is conducive to the miniaturization design of the ultrasonic transducer and improves the applicable range of the ultrasonic transducer, and the corresponding probe operating frequency of the ultrasonic transducer is 1MHz-30MHz.

Optionally, the thickness of the substrate 11 is 50μm, 150μm, 180μm, 200μm, 220μm, 500μm, 1000μm, or 1500μm.

In one example, the length dimension of the substrate 11 is 20mm-25mm, and the width dimension is 20mm-25mm.

Optionally, the length dimension and width dimension of the substrate 11 are the same, both of which are 20mm, 22mm, 23mm, or 25mm.

In some embodiments, the length of the first electrode layer 12 extending to the wiring area 113 is 1mm-3mm. If the size of the first electrode layer 12 exposed to the plurality of piezoelectric array elements 111 is too short the electrical connection operation space between the first conductive element 40 and the first electrode layer 12 is small, the connection length is short, and the connection firmness is poor; if the size of the first electrode layer 12 exposed to the plurality of piezoelectric array elements 111 is too long, the contact area between the first electrode layer 12 and the surrounding environment is increased, which results in greater sensitivity to external interference signals and causes interference and loss of electrical signals.

In some embodiments, the wiring area 113 is located at both ends of the the plurality of piezoelectric array elements 111 in the column direction Y For example, in the column direction Y, one end of the first electrode layer 12 extends to the wiring area 113 for electrical connection with the first conductive element 40. For another example, in the column direction Y, both ends of the first electrode layer 12 extend to the wiring area 113, and the first conductive element 40 can be electrically connected to any end of the first electrode layer 12, or can be alternately connected to both ends of the first electrode layer 12.

In one of the embodiments, in conjunction with FIGS. 1, 4 to 6, both ends of the first electrode layer 12 in the column direction Y extend to the wiring area 113 and are alternately connected with the first conductive element 40 to increase the wire spacing. In other words, in conjunction with FIG. 3 together, the left side of the first electrode layer 12 corresponding to the piezoelectric array elements 111 in the odd columns such as the first column, the third column, and the fifth column, is connected to the first conductive element 40, and the right side of the first electrode layer 12 corresponding to the piezoelectric array elements 111 in the even columns such as the second column, the fourth column, and the sixth column, is connected to the first conductive element 40. At the same end in the column direction Y, the interval between two adjacent electrical connection points is two rows of spacing, which increases the interval between two adjacent electrical connection points compared to the single row spacing, reduces electrical crosstalk, especially when the operating frequency of the ultrasonic transducer is high frequency, and physical separation is achieved at the same time, the electrical connection operation space is increased, which helps to improve circuit performance and stability, and reduce potential signal interference.

In addition, if the interval between two adjacent electrical connection points is small, the diameter of the first conductive circuit 42 in the first conductive element 40 is also required to be small, thereby the manufacturing cost of the ultrasonic transducer is increased.

In some embodiments, the length of the second electrode layer 13 extending to the wiring area 113 is 1mm to 3mm. If the length of the second electrode layer 13 extending to the wiring area 113 is too short, the electrical connection operation space between the second conductive element 50 and the second electrode layer 13 is small, the connection length is short, and the connection firmness is poor; if the length of the second electrode layer 13 extending to the wiring area 113 is too long, the contacting area between the second electrode layer 13 and the surrounding environment is increased, which results in greater sensitivity to external interference signals and causes interference and loss of electrical signals.

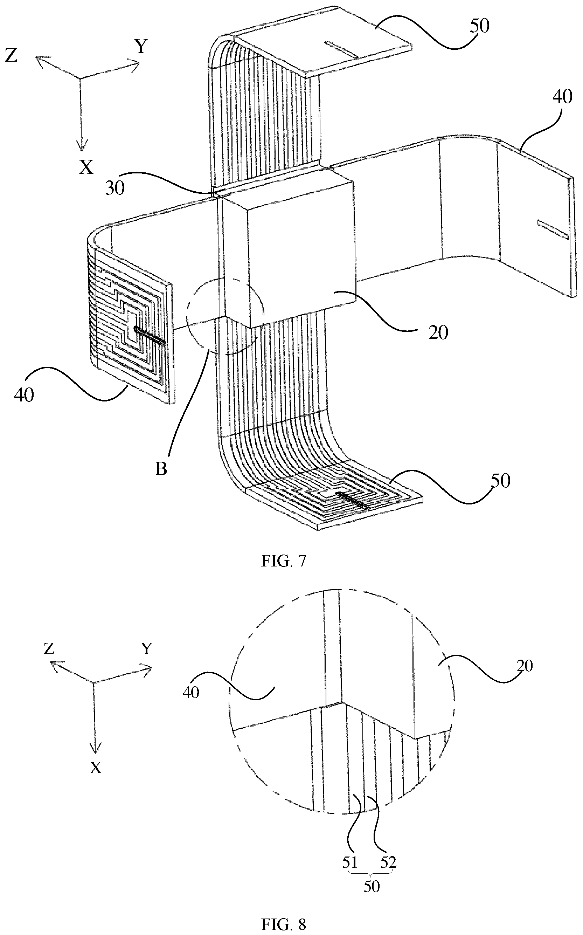

In some embodiments, in combination with FIGS. 7 and 8, the wiring area 113 is located at both ends of the plurality of piezoelectric array elements 111 in the row direction X. For example, in the row direction X, one end of the second electrode layer 13 extends to the wiring area 113 for electrical connection with the second conductive element 50. For another example, in the row direction X, both ends of the second electrode layer 13 extend to the wiring area 113, and the second conductive element 50 can be electrically connected to any end of the second electrode layer 13, or can be alternately connected to both ends of the second electrode layer 13.

In one of the embodiments, in combination with FIGS. 7, 9 to 11, the second electrode layers 13 have the wiring areas 113 at both ends in the row direction X, and are alternately connected with the second conductive element 50 to increase the wire spacing. At the same end in the row direction X, the spacing between two adjacent electrical connection points is two column spacing, which increases the wire spacing between two adjacent electrical connection points compared to the single column spacing, the electrical crosstalk is reduced, and especially when the operating frequency of the ultrasonic transducer is high frequency, physical separation is achieved at the same time, and the electrical connection operation space is increased, which helps to improve circuit performance and stability and reduce potential signal interference.

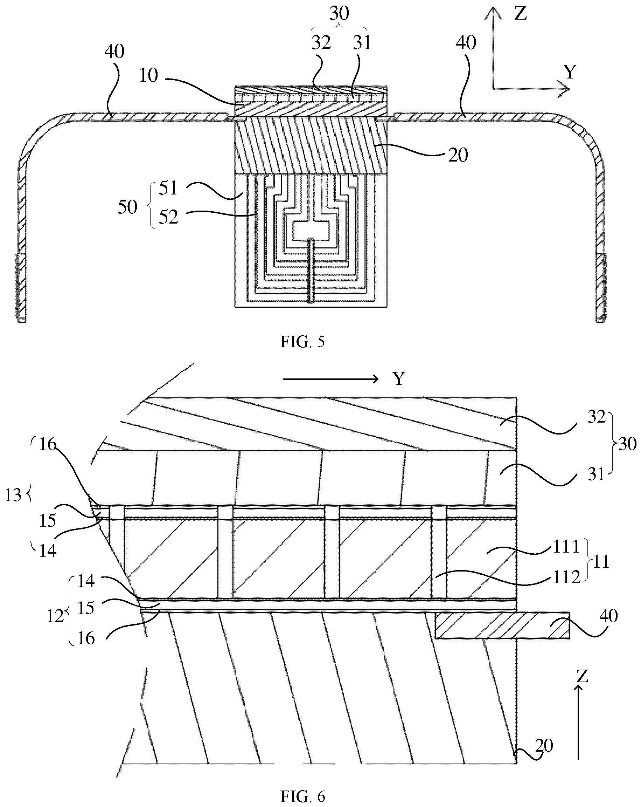

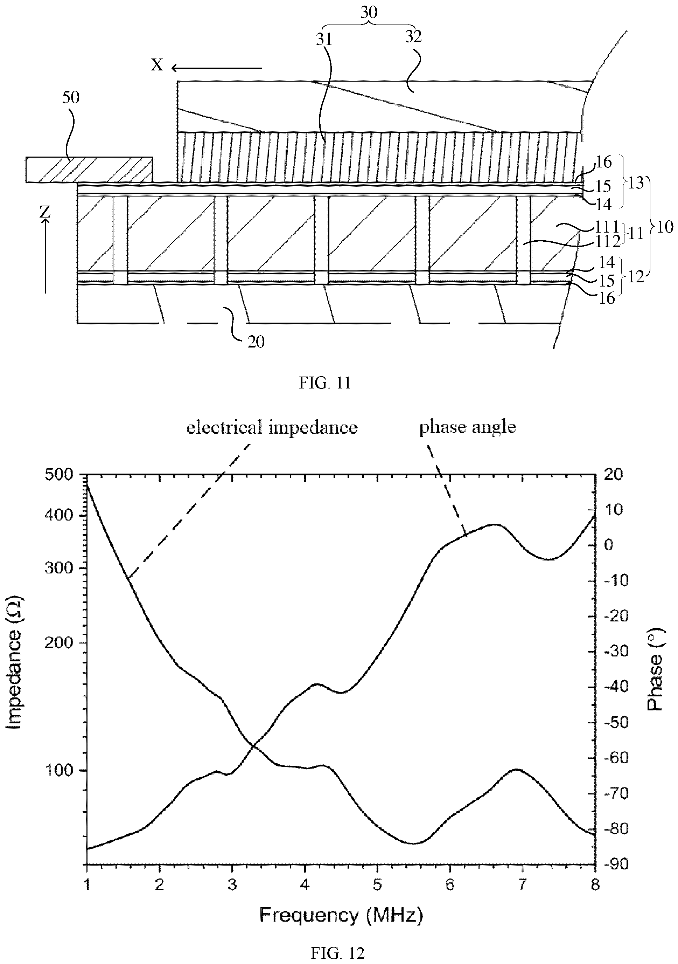

In one of the embodiments, in combination with FIGS. 6 and 11, at least one of the first electrode layer 12 and the second electrode layer 13 includes an adhesion-enhancing layer 14, a main conductive layer 15 and an anti-oxidation layer 16 sequentially laminated on the substrate 11 along the thickness direction Z. The arrangement of the adhesion-enhancing layer 14 can increase the connection strength between the first electrode layer 12 and/or the second electrode layer 13 and the substrate 11, and reduce the possibility of the first electrode layer 12 and/or the second electrode layer 13 falling off due to mechanical vibration or external force. In particular, the piezoelectric array element 111 is cut from a brittle single crystal, and the adhesion-enhancing layer 14 can increase the flexibility of the first electrode layer 12 and/or the second electrode layer 13, which is conducive to maintaining a stable electrical connection, and also prevents adjacent piezoelectric array elements 111 from separating due to cracking. The main conductive layer 15 has low resistance and high conductivity, which is conducive to the transmission of electrical signals and the centralized distribution of electrical energy. The anti-oxidation layer 16 provides anti-oxidation protection for the main conductive layer 15 to prevent the main conductive layer 15 from reducing its conductivity due to oxidation. At the same time, the anti-oxidation layer 16 can extend the service life of the first electrode layer 12 and/or the second electrode layer 13, and improve stability and reliability.

For example, in conjunction with FIG. 6, the first electrode layer 12 corresponds to the position of each column of piezoelectric array elements 111, and each column of piezoelectric array elements 111 includes a plurality of piezoelectric array elements 111 distributed at intervals and an insulating adhesive 112 filling the intervals. The first electrode layer 12 needs to adhere to the piezoelectric array elements 111 and the insulating adhesive 112 at the same time, and there is an interface change. The adhesion-enhancing layer 14 can improve the adhesion between the first electrode layer 12 and the substrate 11 to ensure stable signal transmission.

Specifically, in conjunction with FIGS. 6 and 11, the material of the adhesion-enhancing layer 14 is at least one selected from a group of a chromium, a titanium, an aluminum, a nickel and a tin.

Specifically, the thickness of the adhesion-enhancing layer 14 is 20nm-30nm. In this way, the thickness of the adhesion-enhancing layer 14 is relatively thin, which is conducive to reducing the thickness of the first electrode layer 12 and/or the second electrode layer 13, and avoiding stress concentration between the first electrode layer 12 and/or the second electrode layer 13 and the substrate 11 due to excessive thickness.

Specifically, in conjunction with FIGS. 6 and 11 , the material of the main conductive layer 15 is at least one selected from a group of a copper, a silver and a platinum.

Specifically, the thickness of the main conductive layer 15 is 500nm-3000nm. The thickness of the main conductive layer 15 is the largest in the electrode layers to provide lower resistance and improve conductivity, while also avoiding the thickness exceeding 3000nm, which leads to excessive cost and excessive spacing between the substrate 11 and the acoustic matching layer 30 or the substrate layer 20.

Specifically, in conjunction with FIGS. 6 and 11,

the material of the anti-oxidation layer 16 includes at least one selected from a group of a gold, an aluminum, an iron, a niobium, a zirconium and a stainless steel.

Specifically, the thickness of the anti-oxidation layer 16 is 50nm-100nm. The thickness of the anti-oxidation layer 16 is moderate to prevent oxides from penetrating into the main conductive layer 15. If the thickness is too thin, oxidation problems may occur. If the thickness is too thick, the manufacturing cost may be increased, and the spacing between the substrate 11 and the acoustic matching layer 30 or the substrate layer 20 may be increased.

In one of the embodiments, the thickness of the first electrode layer 12 is less than or equal to $10\mu m$. The first electrode layer 12 has a smaller thickness, which can reduce the interval between the piezoelectric array element 111 and the substrate layer 20, so that the substrate layer 20 can better eliminate the interference of environmental noise on the piezoelectric array element 111. In addition, the relatively thin first electrode layer 12 can better adapt to the slight deformation between the piezoelectric array element 111 and the substrate layer 20, maintain a high mechanical strength, reduce stress concentration caused by mismatch and reduce the risk of material damage, and provide a more uniform stress distribution, which helps to reduce the impedance mismatch in the acoustic wave transmission path and improve the transmission efficiency of the acoustic wave.

In one of the embodiments, the thickness of the second electrode layer 13 is less than or equal to $10\mu m$. The second electrode layer 13 has a smaller thickness, which can reduce the interval between the piezoelectric array element 111 and the acoustic matching layer 30, so that the acoustic matching layer 30 and the piezoelectric array element 111 can better transmit acoustic waves. In addition, the relatively thin second electrode layer 13 can better adapt to the slight deformation between the piezoelectric array element 111 and the acoustic matching layer 30, maintain high mechanical strength, reduce stress concentration caused by mismatch and reduce the risk of material damage, and provide more uniform stress distribution, which helps to reduce impedance mismatch in the acoustic wave transmission path and improve the transmission efficiency of acoustic waves.

In some embodiments, the acoustic matching layer 30 includes a first matching layer 31 and a second matching layer 32 sequentially arranged on the piezoelectric layer 10 along the thickness direction Z, the acoustic impedance of the piezoelectric array element 111 is 25 MRayl-35 MRayl, the acoustic impedance of the first matching layer 31 is less than 20 MRayl and greater than the acoustic impedance of the second matching layer 32, and the acoustic impedance of the second matching layer 32 is greater than 2 MRayl. Through the gradual transition of the two matching layers, the acoustic impedance matching between the piezoelectric array element 111 and the load medium (human body) is achieved, thereby the reflected and transmitted acoustic wave losses is reduced and the transmission efficiency of acoustic energy is improved. Optionally, the acoustic impedance of the second matching layer 32 is less than 15 MRayl.

In one of the embodiments, assuming that the acoustic impedance of the piezoelectric array element 111, the load matrix, the first matching layer 31, and the second matching layer 32 are $Z_p$, $Z_l$, $Z_1$, and $Z_2$, respectively, the following requirements are met:

$$Z_1 = Z_p^{\frac{4}{7}} Z_l^{\frac{3}{7}}; \ Z_2 = Z_p^{\frac{1}{7}} Z_l^{\frac{6}{7}}$$

. In this way, the acoustic impedance matching between the piezoelectric array element 111 and the load matrix can be ensured, the acoustic wave loss caused by reflection and transmission can be reduced, and the transmission efficiency of acoustic energy can be improved.

Optionally, when the load matrix is a human organ, $Z_l$ is 1.65MRayl, the acoustic impedance $Z_1$ of the first matching layer 31 ranges from 6MRayl to 12MRayl, and the acoustic impedance $Z_2$ of the second matching layer 32 ranges from 2MRayl to 4MRayl.

Specifically, the material of the first matching layer 31 is a mixture of a alumina powder and an epoxy resin. Optionally, the first matching layer 31 is made by a high compression (50-70MPa) manufacturing method to increase the acoustic impedance value and reduce attenuation. For example, the acoustic impedance can be increased from 5.6MRayl to 8.54MRayl, which is similar to the acoustic impedance of heavy metals, but much lower than the attenuation of the heavy metals. Among them, the diameter of the alumina powder is $1\mu m$-$2\mu m$, which is much smaller than the wavelength of the acoustic wave, so the scattering effect can be minimized to reduce the attenuation at the designed center frequency.

Optionally, the ratio of the alumina powder to the epoxy resin is 2:1.

Specifically, the material of the second matching layer 32 is the epoxy resin.

Optionally, the material of the second matching layer 32 is the epoxy resin 301.

Specifically, the thickness of the first matching layer 31 is $90\mu m$-$110\mu m$. Optionally, the thickness of the first matching layer 31 is $90\mu m$, $95\mu m$, $100\mu m$, $105\mu m$, or $110\mu m$.

Specifically, the thickness of the second matching layer 32 is $50\mu m$~$70\mu m$. Optionally, the thickness of the second matching layer 32 is $50\mu m$, $55\mu m$, $60\mu m$, $65\mu m$, or $70\mu m$.

In some embodiments, the acoustic matching layer 30 covers a plurality of piezoelectric array elements 111, but does not cover the wiring area 113. It is understood that in other embodiments, the acoustic matching layer 30 covers the entire substrate 10, and a step for accommodating the second conductive element 50 located on the wiring area 113 is provided at the end in the row direction Y

In some embodiments, the substrate layer 20 can absorb useless acoustic waves on the back of the piezoelectric array elements 111 when the ultrasonic transducer is working, the quality of the two-dimensional array ultrasonic transducer is greatly improved.

Optionally, the acoustic impedance value of the substrate layer 20 is 5MRayl-10MRayl.

Specifically, the substrate layer 20 is an insulating substrate structure, and the preparation material of the substrate layer 20 can be a common material, for example, the common material can be a mixture of low-viscosity epoxy resin glue and tungsten powder; in other embodiments, the preparation material of the substrate layer 20 can also be selected from other common materials, for example, the common material can be a mixture of low-viscosity epoxy resin glue and bismuth oxide, and the common material can also be other mixtures, which is not limited herein, the selection of the common material can be depended on the specific situation. It should be noted that the difference between the above two preparation materials lies in the different absorption capacity of acoustic wave energy. Optionally, the material of the substrate layer 20 is a mixture of $Al_2O_3$ powder and the epoxy resin 301, which can achieve acoustic attenuation in a wide frequency range.

Specifically, the thickness of the substrate layer 20 is 3mm-10mm. The greater the thickness of the substrate layer 20, the greater the volume of the corresponding substrate layer 20, but the better the absorption effect of the residual wave will be. The smaller the thickness of the substrate layer 20, the smaller the volume of the corresponding substrate layer 20, but the worse the absorption effect of the residual wave will be. In view of the above situation, in order to obtain a substrate layer 20 with a smaller volume and meet the existing requirements for the absorption effect of the residual wave, the thickness of the substrate layer 20 can be set to a value range of 3mm-10mm. For example, the thickness of the substrate layer 20 is 3mm, 5mm, 6mm, 8mm or 10mm.

Specifically, in conjunction with FIGS. 5 and 6, the substrate layer 20 covers the entire piezoelectric layer 10, and the substrate layer 20 is provided with a step for accommodating the first conductive element 40 at the end of the column direction Y, so that the substrate layer 20 covers the first electrode layer 12 and the first conductive element 40 located in the wiring area 113, and the influence of environmental noise on the substrate 11 or the first electrode layer 12 is eliminated.

In some embodiments, the first conductive element 40 includes a first insulating plate 41 and a plurality of first conductive circuits 42 laid on the first insulating plate 41. The number of the first conductive circuits 42 is the same as the number of the first electrode layers 12 and corresponds one to one. In this way, the plurality of first conductive circuits 42 have strong integrity, and only need to be positioned by the first insulating plate 41 and the substrate 11 to realize the alignment of the plurality of first conductive circuits 42 and the plurality of first electrode layers 12, which is convenient for electrical connection operation. Optionally, the first conductive element 40 is a flexible circuit board.

In some embodiments, the second conductive element 50 includes a second insulating plate 51 and a plurality of second conductive circuits 52 laid on the second insulating plate 51. The number of the second conductive circuits 52 is the same as the number of the second electrode layers 13 and corresponds one to one. In this way, the plurality of second conductive circuits 52 have strong integrity, and only need to be positioned by the second insulating plate 51 and the substrate 11 to realize the the alignment of the plurality of second conductive circuits 52 and the plurality of second electrode layers 13, which is convenient for electrical connection operation. Optionally, the second conductive element 50 is a flexible circuit board.

In some embodiments, the center frequency of the ultrasonic transducer is 1 MHz-30 MHz.

Optionally, the center frequency of the ultrasonic transducer is 1 MHz, 4 MHz, 8 MHz, 10 MHz, 20 MHz, or 30 MHz.

The insertion loss test of the ultrasonic transducer provided in the embodiment is carried out, the acoustic matching layer 30 of the ultrasonic transducer is immersed in water, and the signal generator is arranged to a waveform excitation of a single-tone burst mode with an amplitude of 5 cycles at the center frequency of the ultrasonic transducer. The pulse ultrasonic wave is reflected by a 40mm thick stainless steel block in water 3mm away from the ultrasonic transducer. The pulse echo signal ($V_i$) and the pulse ultrasonic wave ($V_o$) are displayed on the oscilloscope. By comparing the amplitudes of the pulse echo signal ($V_i$) and the pulse ultrasonic wave ($V_o$), the insertion loss can be obtained,

$$IL = -20log\left(\frac{V_o}{V_i}\right)$$, where the insertion loss IL is 49.0dB, which is a small value. In addition, in conjunction with FIG. 12, the thickness of the substrate 11 is 200$\mu$m and the thickness of the first matching layer 31 is 100$\mu$m. The thickness of the second matching layer 32 is 66$\mu$m. The impedance and phase diagram of the 29th row are measured in air with a precision impedance analyzer.

According to $k_t = \sqrt{\frac{\pi}{2} \times \frac{f_s}{f_p} \times \tan\left(\frac{\pi}{2} \times \frac{f_p-f_s}{f_p}\right)}$, the electromechanical coupling coefficient kt is calculated to be 0.64, which is significantly higher than that of the traditional transducer. Where fs is the resonance frequency at which the conductance reaches the minimum, and fp is the parallel resonance frequency at which the resistance reaches the maximum. According to FIG. 12, fs is 5.5MHz and fp is 6.9MHz.

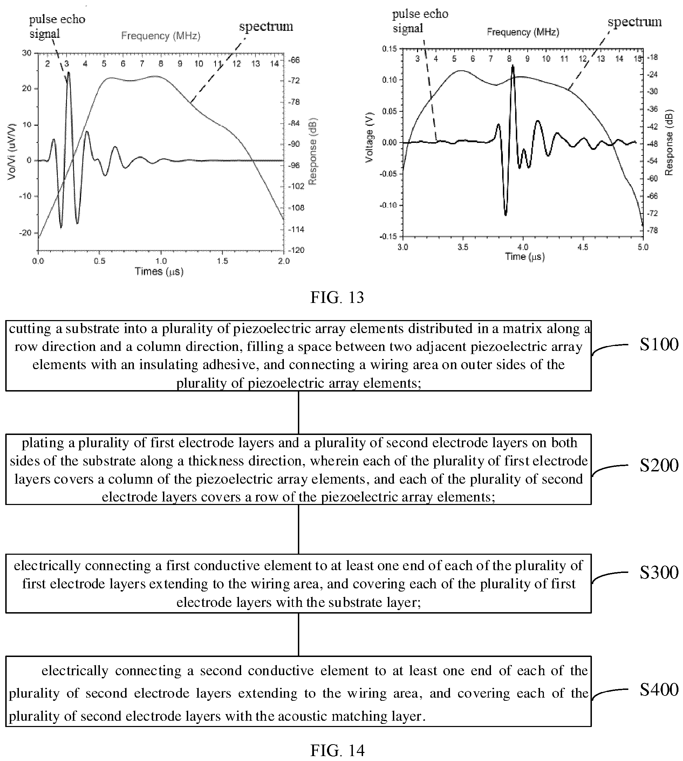

Combined with FIG. 13, in the two-way pulse-echo measurement, the ultrasonic transducer immersed in the acoustic coupling agent is excited separately by the pulser/receiver at a repetition rate of 2 kHz, and the energy of the pulser/receiver is 4$\mu$J. The electrical cou-

pling and gain of the device and signal amplifier are arranged to 50Ω and 26dB, respectively. The fast Fourier transform (FFT) in the math function of the oscilloscope is used to convert the time domain signal to the frequency domain spectrum. FIG. 13 (b) shows the acoustic response of a representative element located at the center of the transducer (60, 60). The average peak-to-peak amplitude of the pulse-echo response is 121mV (gain is 26dB), and the -6dB bandwidth from 4.27MHz to 11MHz is about 88% at the center frequency of 6.73MHz.

**Embodiment 2**

As shown in FIG. 14, the present application provides a method for preparing an ultrasonic transducer, the method comprising the following steps:

In a step S100: a substrate 11 is cut into a plurality of piezoelectric array elements 111 distributed in a matrix along the row direction X and the column direction Y, respectively, the insulating adhesive 112 is filled in the interval between two adjacent piezoelectric array elements 111, and the wiring area 113 is connected on the outside of the plurality of piezoelectric array elements 111.

In a step S200: a plurality of first electrode layers 12 and a plurality of second electrode layers 13 are plated on both sides of the substrate 11 along the thickness direction Z, each of the plurality of first electrode layers 12 covers a column of the piezoelectric array elements 111, and each of the plurality of second electrode layers 13 covers a row of the piezoelectric array elements 111;

In a step S300: the first conductive element 40 is electrically connected to at least one end of the first electrode layer 12 extending to the wiring area 113, and the first electrode layer 12 is covered with the substrate layer 20.

In a step S400: the second conductive element 50 is electrically connected to at least one end of the second electrode layer 13 extending to the wiring area 113, and the acoustic matching layer 30 covers the second electrode layer 13.

The steps S200, S300 and S400 can be performed sequentially or crosswise. For example, the first electrode layers 12 are manufactured in the step S200 first, then the step S300 is performed, and then the second electrode layer 13 is manufactured in the step S200, and then the step S400 is performed.

In the embodiment, at least one end of the first electrode layer 12 extends to the wiring area 113, which is convenient for electrical connection with the first conductive element 40. The first conductive element 40 is not arranged between the plurality of piezoelectric array elements 111 and the substrate layer 20, so that the piezoelectric layer 10 and the substrate layer 20 can be directly in contact for acoustic matching, thereby the efficiency of acoustic wave transmission and the clarity and quality of ultrasonic signals are improved. At least one end of the second electrode layer 13 extends to the wiring area 113, which is convenient for electrical connection with the second conductive element 50. The second conductive element 50 is not arranged between the plurality of piezoelectric array elements 111 and the acoustic matching layer 30, so that the piezoelectric layer 10 and the acoustic matching layer 30 can be in direct contact for acoustic matching, thereby the efficiency of acoustic wave transmission and the clarity and quality of the ultrasonic signal are improved. Therefore, the acoustic matching effect between the piezoelectric array element 111 and the substrate layer 20 and the acoustic matching layer 30 is improved.

In one of the embodiments, step S100 includes the following steps:

In a step S101: the substrate 11 is ground to flatten the surface of the substrate 11, so as to facilitate the subsequent deposition of the first electrode layer 12 and the second electrode layer 13, and at the same time control the thickness of the substrate 11 by grinding.

In a step S102: the polished substrate 11 is polished. Optionally, 4000 grit aluminum oxide is used for polishing.

In a step S103: the substrate 11 is cut along the row direction X. Optionally, a blade having a thickness smaller than a preset interval between adjacent piezoelectric array elements 111 is used for cutting. For example, if the preset interval is 30μm, the thickness of the blade is selected to be 25μm.

In a step S104: an insulating adhesive 112 with a viscosity of 80cPs-100cPs is used to fill the incisions formed by cutting the substrate 11 along the row direction X, and the insulating adhesive 112 is then cured. Optionally, the filling is performed at 23°C, and the curing time is 20 hours to 30 hours.

In a step S105: the substrate 11 is cut along the column direction Y. Optionally, a blade with a thickness less than the preset interval between adjacent piezoelectric array elements 111 is used for cutting.

In a step S106: use an insulating adhesive 112 with a viscosity of 80cPs-100cPs is used to fill the incisions formed by cutting the substrate 11 along the column direction Y. Optionally, the filling is performed at 23 °C, and the curing time is 20 hours to 30 hours.

In a step S107: the substrate 11 is ground to remove excess insulating adhesive 112. Optionally, the step S107 can be performed once after the step S104 and the step S106.

Optionally, the support body 114 of the wiring area 113 can be cut from the substrate 11, that is, the plurality of piezoelectric array elements 111 and the plurality of support bodies 114 are cut out at the same time in the step S103 and the step S105, and then the insulating adhesive 112 is filled between the plurality of support bodies 114 and between the support bodies 114 and the piezoelectric array elements 111 at the same time in the step S104 and the step S106 to improve production efficiency. It can be understood that in other embodiments, the support body 114 can also be insulating ceramic, glass or high-resistance silicon wafer, which is not limited here.

In one of the embodiments, the step S200 includes the following steps:

In a step S201: the adhesion-enhancing layer 14, the main conductive layer 15 and the anti-oxidation layer 16 are sputtered and deposited on both sides of the substrate 11 in sequence, so that the first electrode layers 12 and the second electrode layers 13 are formed on both sides of the substrate 11. Optionally, the first electrode layers 12 and the second electrode layers 13 are formed by magnetron sputtering.

In a step S202: the first electrode layer 12 is cut along the column direction Y, and the incisions formed by the cutting is filled with insulating adhesive 112. Optionally, the cutting tool, cutting position, and cutting parameters are consistent with the step S105. It is understood that in other embodiments, photolithography can also be used to separate the first electrode layer 12 into strips.

In a step S203: the second electrode layer 13 is cut along the row direction X, and the incisions formed by the cutting is filled with insulating adhesive 112. Optionally, the cutting tool, cutting position, and cutting parameters are consistent with the step S103. It is understood that in other embodiments, photolithography can also be used to separate the second electrode layer 13 into strips.

In the step S200, the steps S201, S202, and S203 can be performed in sequence, or the first electrode layer 12 in the step S201 can be firstly sputtered on one side of the substrate 11, and the step S202 is performed, and then the second electrode layer 13 in step S201 can be sputtered on the other side of the substrate 11, and the step S203 is performed.

Furthermore, after the step S203, the preparation method further includes a step S204: the substrate 11 is polarized for 30 minutes at room temperature under a constant electric field of 10 kV/cm. The polarized area is the array element area, and the wiring area 113 is not polarized, that is, the wiring area 113 does not generate a piezoelectric signal and does not actively generate mechanical vibration.

In one of the embodiments, the step of electrically connecting the first conductive element 40 to at least one end of the first electrode layer 12 specifically includes the following steps:

In a step S301: the first conductive element 40 is alternately connected to the two ends of the first electrode layer 12.

In a step S302: the end of the first conductive element 40 is fixed to the first electrode layer 12 using an insulating adhesive 112.

In a step S303: the bonding pad of the first conductive element 40 is compressed to connect the bonding pad of the first conductive element 40 to the end of the first electrode layer 12. Compressing the bonding pad can increase the contact area and adhesion between the bonding pad and the first electrode layer 12, effectively reduce the presence of an oxide layer or contaminants between the contact surfaces, and reduce resistance on the other hand. Optionally, after welding, the soldering is cured in an oven at 65 °C for 3 hours.

Optionally, after the step S303, the step S304 is also included: a multimeter is used to check whether there is a short circuit.

In one of the embodiments, the step of electrically connecting the second conductive element 50 to at least one end of the second electrode layer 13 specifically includes following steps:

In a step S401: the second conductive element 50 is alternately connected to the two ends of the second electrode layer 13.

In a step S402: the end of the second conductive element 50 is fixed to the second electrode layer 13 using an insulating adhesive 112.

In a step S403: the bonding pad of the second conductive element 50 is compressed to connect the bonding pad of the second conductive element 50 to the end of the second electrode layer 13. Compressing the bonding pad can increase the contact area and adhesion between the bonding pad and the second electrode layer 13, effectively reduce the presence of an oxide layer or contaminants between the contact surfaces, and reduce resistance. Optionally, after welding, the soldering is cured in an oven at 65 °C for 3 hours.

Optionally, after the step S403, a step S404 is also included: a multimeter is used to check whether there is a short circuit.

## Claims

1. An ultrasonic transducer, comprising:

a substrate layer (20), a piezoelectric layer (10), and an acoustic matching layer (30) laminated in sequence along a thickness direction (Z); wherein the piezoelectric layer (10) comprises a substrate (11); the substrate (11) comprises a wiring area (113) and a plurality of piezoelectric array elements (111) distributed at intervals in a matrix along a row direction (X) and a column direction (Y), two adjacent piezoelectric array elements (111) are bonded by an insulating adhesive (112), and the wiring area (113) is connected to outer sides of the plurality of piezoelectric array elements (111); a plurality of first electrode layers (12) distributed at intervals in the row direction (X) are arranged on a side of the substrate (11) adjacent to the substrate layer (20), each of the plurality of first electrode layers (12) covers a column of the piezoelectric array elements (111), a plurality of second electrode layers (13) distributed at intervals in the column direction (Y) are arranged on a side of the substrate (11) adjacent to the acoustic matching layer (30), each of the plurality of second electrode layers (13) covers a row of the piezoelectric array elements (111); and the thickness direction (Z) is perpendicular to the row direction (X) and the column direction (Y) respectively; and

wherein at least one end of each of the plurality of first electrode layers (12) in the column direction (Y) extends to the wiring area (113), and is electrically connected to a first conductive element (40) in the wiring area (113); at least one end of each of the plurality of second electrode layers (13) in the row direction (X) extends to the wiring area (113), and is electrically connected to a second conductive element (50) in the wiring area (113).

2. The ultrasonic transducer according to claim 1, wherein both ends of each of the plurality of first electrode layers (12) in the column direction (Y) extend to the wiring area (113) and are alternately connected with the first conductive element (40); and/or, both ends of each of the plurality of second electrode layers (13) in the row direction (X) extend to the wiring area (113) and are alternately connected with the second conductive element (50).

3. The ultrasonic transducer according to claim 1, wherein a length of each of the plurality of first electrode layers (12) extends to the wiring area (113) is 1mm-3mm; and/or, a length of each of the plurality of second electrode layers (13) extends to the wiring area (113) is 1mm-3mm.

4. The ultrasonic transducer according to claim 1, wherein each of the plurality of first electrode layers (12) and/or each of the plurality of second electrode layers (13) comprises an adhesion-enhancing layer (14), a main conductive layer (15), and an anti-oxidation layer (16) sequentially laminated on the substrate (11) along the thickness direction (Z).

5. The ultrasonic transducer according to claim 4, wherein a material of the adhesion-enhancing layer (14) is at least one selected from a group of a chromium, a titanium, an aluminum, a nickel, and a tin, a material of the main conductive layer (15) is at least one selected from a group of a copper, a silver, and a platinum, and a material of the anti-oxidation layer (16) comprises at least one selected from a group of a gold, an aluminum, an iron, a niobium, a zirconium, and a stainless steel.

6. The ultrasonic transducer according to claim 4, wherein a thickness of the adhesion-enhancing layer (14) is 20nm-30nm, a thickness of the main conductive layer (15) is 500nm-3000nm, and a thickness of the anti-oxidation layer (16) is 50nm-100nm.

7. The ultrasonic transducer according to claim 1, wherein a thickness of each of the plurality of first electrode layers (12) is less than or equal to 10 $\mu$ m, and/or a thickness of each of the plurality of second electrode layers (13) is less than or equal to 10 $\mu$ m.

8. The ultrasonic transducer according to claim 1, wherein a material of each of the plurality of piezoelectric array elements (111) is at least one selected from a group of a lead magnesium niobate titanate single crystal, a barium titanate barium yttrium lead zenate single crystal, a zirconium beryllium titanate single crystal, a sodium niobate phosphate single crystal, and a lithium niobate single crystal; a material of the insulating adhesive (112) is at least one selected from a group of an epoxy resin, a polyurethane, a polyimide, and a polysulfone; both ends of the substrate (11) in the row direction (X) are exposed to the acoustic matching layer (30); and a thickness of the substrate (11) is 50 $\mu$ m-1500 $\mu$ m.

9. The ultrasonic transducer according to claim 1, wherein the acoustic matching layer (30) comprises a first matching layer (31) and a second matching layer (32) sequentially arranged on the piezoelectric layer (10) along the thickness direction (Z), an acoustic impedance of each of the plurality of piezoelectric array elements (111) is 25 MRayl-35 MRayl, an acoustic impedance of the first matching layer (31) is less than 20 MRayl and greater than an acoustic impedance of the second matching layer (32), and the acoustic impedance of the second matching layer (32) is greater than 2 MRayl.

10. The ultrasonic transducer according to claim 9, wherein the acoustic matching layer (30) further comprises at least one of following features:

a material of the first matching layer (31) is a mixture of an alumina powder and an epoxy resin;
a material of the second matching layer (32) is the epoxy resin;
a thickness of the first matching layer (31) is 90$\mu$m-110$\mu$m; and
a thickness of the second matching layer (32) is 50$\mu$m-70$\mu$m.

11. The ultrasonic transducer according to any one of claims 1 to 10, wherein a center frequency of the ultrasonic transducer is 1 MHz-30 MHz, and a thickness of the substrate layer (20) is 3mm-10 mm.

12. A method for preparing an ultrasonic transducer according to claim 1, comprising following steps:

S100: cutting a substrate (11) into a plurality of piezoelectric array elements (111) distributed in a matrix along a row direction (X) and a column direction (Y), filling a space between two adjacent piezoelectric array elements (111) with an insulating adhesive (112), and connecting a wiring area (113) on outer sides of the plurality of piezoelectric array elements (111);

S200: plating a plurality of first electrode layers (12) and a plurality of second electrode layers (13) on both sides of the substrate (11) along a thickness direction (Z), wherein each of the plurality of first electrode layers (12) covers a column of the piezoelectric array elements (111), and each of the plurality of second electrode layers (13) covers a row of the piezoelectric array elements (111);

S300: electrically connecting a first conductive element (40) to at least one end of each of the plurality of first electrode layers (12) extending to the wiring area (113), and covering each of the plurality of first electrode layers (12) with the substrate layer (20); and

S400: electrically connecting a second conductive element (50) to at least one end of each of the plurality of second electrode layers (13) extending to the wiring area (113), and covering each of the plurality of second electrode layers (13) with the acoustic matching layer (30).

13. The method for preparing the ultrasonic transducer according to claim 12, wherein the step S100 comprises following steps:

S101: grinding the substrate (11);
S102: polishing the substrate (11) after grinding;
S103: cutting the substrate (11) along the row direction (X);
S104: filling incisions formed by cutting the substrate (11) along the row direction (X) with the insulating adhesive (112) having a viscosity of 80cPs-100cPs, and curing the insulating adhesive (112);
S105: cutting the substrate (11) along the column direction (Y);
S106: filling incisions formed by cutting the substrate (11) along the column direction (Y) with the insulating adhesive (112) having a viscosity of 80cPs-100cPs, and curing the insulating adhesive (112);
S107: grinding the substrate (11) to remove excess insulating adhesive (112).

14. The method for preparing the ultrasonic transducer according to claim 12, wherein the step S200 comprises following steps:

S201: sputtering and depositing an adhesion-enhancing layer (14), a main conductive layer (15), and an anti-oxidation layer (16) on both sides of the substrate (11) in sequence, so that the plurality of first electrode layers (12) and the plurality of second electrode layers (13) are formed on both sides of the substrate (11) respectively;
S202: cutting the plurality of first electrode layers (12) along the column direction (Y), and filling incisions formed by the cutting with the insulating adhesive (112); and
S203: cutting the plurality of second electrode layer along the row direction (X), and filling incisions formed by the cutting with with insulating adhesive (112).

15. The method for preparing the ultrasonic transducer according to any one of claims 12 to 14, wherein the step of electrically connecting the first conductive element (40) to at least one end of the plurality of first electrode layers (12) specifically comprises:

S301: alternately connecting the first conductive element (40) to both ends of each of the plurality of first electrode layers (12);
S302: fixing an end of the first conductive element (40) to each of the plurality of first electrode layers (12) by the insulating adhesive (112); and
S303: compressing a bonding pad of the first conductive element (40) to connect the bonding pad of the first conductive element (40) to an end of each of the plurality of first electrode layers (12).

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

| | |
|---|---|
| cutting a substrate into a plurality of piezoelectric array elements distributed in a matrix along a row direction and a column direction, filling a space between two adjacent piezoelectric array elements with an insulating adhesive, and connecting a wiring area on outer sides of the plurality of piezoelectric array elements; | S100 |
| plating a plurality of first electrode layers and a plurality of second electrode layers on both sides of the substrate along a thickness direction, wherein each of the plurality of first electrode layers covers a column of the piezoelectric array elements, and each of the plurality of second electrode layers covers a row of the piezoelectric array elements; | S200 |
| electrically connecting a first conductive element to at least one end of each of the plurality of first electrode layers extending to the wiring area, and covering each of the plurality of first electrode layers with the substrate layer; | S300 |
| electrically connecting a second conductive element to at least one end of each of the plurality of second electrode layers extending to the wiring area, and covering each of the plurality of second electrode layers with the acoustic matching layer. | S400 |

FIG. 14

Europäisches
Patentamt

European
Patent Office

Office européen
des brevets

# EUROPEAN SEARCH REPORT

**Application Number**

EP 24 21 4587

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ENGHOLM MATHIAS ET AL: "Probe development of CMUT and PZT row-column-addressed 2-D arrays", SENSORS AND ACTUATORS A: PHYSICAL, vol. 273, 21 February 2019 (2019-02-21), pages 1-14, XP093119125, NL ISSN: 0924-4247, DOI: 10.1016/j.sna.2018.02.031 Retrieved from the Internet: URL:https://backend.orbit.dtu.dk/ws/portal files/portal/146185126/sa_2018_engholm.pdf > | 1-7,9-15 | INV. B06B1/06 |
| Y | * abstract * * figures 1,2,4-6 * * pages 1-6 * * tables 1,2 * | 8 | |
| X | US 2021/302388 A1 (ZHANG JINCHI [CA] ET AL) 30 September 2021 (2021-09-30) * abstract * * figures 1-5 * * paragraphs [0022] - [0041] * * paragraphs [0058] - [0097] * | 1-15 | |
| X | US 2019/328360 A1 (FERIN GUILLAUME [FR] ET AL) 31 October 2019 (2019-10-31) * abstract * * figures 1,2,5 * * pages 1-7 * | 1-15 | TECHNICAL FIELDS SEARCHED (IPC) B06B |
| Y | WO 2017/143307 A1 (UNIV SOUTHERN CALIFORNIA [US] ET AL.) 24 August 2017 (2017-08-24) * paragraphs [0006], [0012], [0013], [0051] * | 8 | |

The present search report has been drawn up for all claims

| Place of search | Date of completion of the search | Examiner |
|---|---|---|
| The Hague | 4 April 2025 | Meyer, Matthias |

EPO FORM 1503 03.82 (P04C01)

## ANNEX TO THE EUROPEAN SEARCH REPORT
## ON EUROPEAN PATENT APPLICATION NO.

EP 24 21 4587

This annex lists the patent family members relating to the patent documents cited in the above-mentioned European search report.
The members are as contained in the European Patent Office EDP file on
The European Patent Office is in no way liable for these particulars which are merely given for the purpose of information.

04-04-2025

| Patent document cited in search report | | Publication date | Patent family member(s) | | Publication date |
|---|---|---|---|---|---|
| US 2021302388 | A1 | 30-09-2021 | CA | 3177501 A1 | 07-10-2021 |
| | | | CA | 3177509 A1 | 07-10-2021 |
| | | | CN | 115362388 A | 18-11-2022 |
| | | | CN | 115380223 A | 22-11-2022 |
| | | | EP | 4118453 A1 | 18-01-2023 |
| | | | EP | 4121796 A1 | 25-01-2023 |
| | | | US | 2021302383 A1 | 30-09-2021 |
| | | | US | 2021302388 A1 | 30-09-2021 |
| | | | WO | 2021195757 A1 | 07-10-2021 |
| | | | WO | 2021195758 A1 | 07-10-2021 |
| US 2019328360 | A1 | 31-10-2019 | CN | 112041091 A | 04-12-2020 |
| | | | EP | 3787807 A1 | 10-03-2021 |
| | | | US | 2019328360 A1 | 31-10-2019 |
| | | | WO | 2019211755 A1 | 07-11-2019 |
| WO 2017143307 | A1 | 24-08-2017 | US | 2020046320 A1 | 13-02-2020 |
| | | | US | 2022079559 A1 | 17-03-2022 |
| | | | WO | 2017143307 A1 | 24-08-2017 |

EPO FORM P0459

For more details about this annex : see Official Journal of the European Patent Office, No. 12/82